# EUROPÄISCHE PATENTSCHRIFT

(11) **EP 1 656 230 B1**
(45) Veröffentlichungstag und Bekanntmachung des Hinweises auf die Patenterteilung: **05.04.2017**
(21) Anmeldenummer: 04763315.1
(22) Anmeldetag: 17.07.2004
(51) Int. Cl.: B23K 20/10

(54) **KAMERAUNTERSTÜTZTE JUSTAGE VON BONDKOPFELEMENTEN**
CAMERA SUPPORTED ADJUSTMENT OF BOND HEAD ELEMENTS
AJUSTAGE D'ELEMENTS DE TETE DE SOUDAGE ASSISTE PAR CAMERA

(30) Priorität: 21.08.2003 DE 10338809
(43) Veröffentlichungstag der Anmeldung: 17.05.2006
(73) Patentinhaber: Hesse GmbH, 33104 Paderborn (DE)
(72) Erfinder: WALTHER, Frank, 33034 Brakel (DE)
(74) Vertreter: Wickord, Wiro
(86) Internationale Anmeldenummer: PCT/EP2004/008018
(87) Internationale Veröffentlichungsnummer: WO 2005/028150

(56) Entgegenhaltungen:
- US-A- 5 340 011
- US-A1- 2002 104 870

## Beschreibung

Die Erfindung betrifft ein Verfahren und eine Vorrichtung zur Durchführung von Einstellarbeiten an einem Bondkopf, wobei ein Bondkopfelement relativ zu einem Bezugselement, wie z.B. einem Ultraschallwerkzeug, insbesondere dessen Spitze positioniert wird.

Aus der US 5,340,011 A ist bekannt, ein Ultraschallwerkzeug mithilfe einer Kamera korrekt über einem Substrat in der x-y-Ebene des Bonders zu positionieren. Mit der Kamera verbunden ist ein Monitor als Anzeigeeinheit.

Bei Ultraschallbondern, die einen Bondkopf mit einem daran befestigten Ultraschallwerkzeug aufweisen, um beispielsweise Drahtbondungen durchzuführen, ist es bekannt, dass diverse Bondkopfelemente relativ zu dem Ultraschallwerkzeug und insbesondere relativ zu dessen Spitze positioniert werden müssen.

Beispielsweise bedarf es einer genauen Positionierung einer Drahtzuführung relativ zur Spitze des Ultraschallwerkzeuges, um sicherzustellen, dass der zugeführte Draht immer genau unter der Spitze des Ultraschallwerkzeuges, beispielsweise in einer V-förmigen Rille zu liegen kommt. Eine genaue Positionierung der Drahtzuführung relativ zur Spitze des Ultraschallwerkzeuges ist nötig, damit Drahtbondungen in einwandfreier Qualität hergestellt werden können.

Ebenso bedarf es beim Einsatz eines separaten Messers zum Durchtrennen des Bonddrahtes oder um eine Sollbruchstelle zu erzeugen, ebenfalls einer genauen Positionierung eines solchen Messers relativ zum Ultraschallwerkzeug.

Bekannt ist, es derartige Positionierungen durch den Benutzer eines Ultraschallbonders per Hand vorzunehmen. Dies weist erfahrungsgemäß große Ungenauigkeiten auf, da der bedienende Benutzer auf sein Augenmaß angewiesen ist, um eine hinreichend genaue Positionierung dieser Elemente zueinander zu erreichen. Die manuelle Positionierung kann jedoch in vielen Fällen als nicht ausreichend angesehen werden, so dass die Qualität der Bondungen gegebenenfalls zu wünschen übrig lässt bzw. explizit Fehlbondungen hergestellt werden.

Aufgabe der Erfindung ist, es ein Verfahren und/oder einen Ultraschallbonder bereitzustellen, mit denen eine genaue Positionierung eines Bondkopfelementes relativ zu einem Bezugselement, wie z.B. dem Ultraschallwerkzeug, ermöglicht wird.

Zur Lösung der Aufgabe weist die Erfindung die Merkmale der unabhängigen Patentansprüche 1 und 11 auf.

Ein solches erfindungsgemäßes Verfahren kann beispielsweise durchgeführt werden mittels eines Ultraschallbonders, der zur Unterstützung der Positionierung eines Bondkopfelementes eine Kamera aufweist, mittels der wenigstens eine Umgebung des Bezugselementes, z.B. der Spitze des Ultraschallwerkzeuges optisch erfassbar ist. Eine derartige Kamera kann direkt am Ultraschallbonder vorgesehen sein oder eine separate Vorrichtung darstellen, so dass auch bestehende Ultraschallbonder für die Durchführung des erfindungsgemäßen Verfahrens nachrüstbar sind.

Durch die optische Erfassung wenigstens einer Umgebung des Bezugselementes, wie z.B. der Spitze des Ultraschallwerkzeuges ergibt sich eine insbesondere auf einer Anzeigevorrichtung dargestellte vergrößerte Abbildung, beispielsweise der Spitze des Ultraschallwerkzeuges und der darum angeordneten weiteren Bondkopfelemente, wie beispielsweise eine Drahtzuführung und/oder ein Messer oder andere zu justierende Elemente.

Durch die Erfassung und Anzeige des entsprechenden Bildes der Umgebung des Bezugselementes, insbesondere der Spitze eines Ultraschallwerkzeuges sowie einer Markierung als Hilfsmittel wird eine Bedienerperson entlastet und muss sich nicht mehr auf das Augenmaß bei der Betrachtung des Ultraschallwerkzeuges verlassen. Insbesondere wird durch eine bevorzugte vergrößerte Darstellung eine erhöhte Genauigkeit bei der Positionierung der Elemente untereinander erreicht, wofür es erfindungsgemäß vorgesehen ist, dass eine gewünschte Position, mithin eine optimale Position eines Bondkopfelementes relativ zum Bezugselement z.B. dem Ultraschallwerkzeug durch eine Markierung in der Abbildung dargestellt wird, an der sich eine Bedienerperson orientieren kann.

Ein Bondkopfelement kann derart eingestellt werden, dass es in der Abbildung in der gewünschten Position relativ zum Bezugselement erscheint, beispielsweise dadurch dass ein Justagepunkt an einem Bondkopfelement mit der Markierung in Übereinstimmung gebracht wird. Auch kann es vorgesehen sein, dass die Markierung die Kontur des zu justierenden Bondkopfelementes nachbildet und das Bondkopfelement in diese Kontur hineinpositioniert wird.

Bevorzugt kann es auch vorgesehen sein, dass eine Markierung in Form eines Toleranzfeldes in der Abbildung relativ zum Bezugselement, insbesondere relativ zur Spitze des Ultraschallwerkzeuges dargestellt wird. Durch die Anzeige eines Toleranzfeldes erschließt sich dem Benutzer ein Bereich, in den das einzustellende Bondkopfelement zu positionieren ist. Beispielsweise kann dann eine markante Stelle des Bondkopfelemente, z.B. dessen Spitze in dieses Toleranzfeld hineinpositioniert werden. Hierbei kann ein Toleranzfeld beispielsweise innerhalb der Abbildung in Form einer rechteckigen Darstellung paralleler Linien, gegebenenfalls auch nur durch zwei parallele Linien, oder wenn es keine Toleranzen gibt, durch ein Kreuz gegeben sein.

Eine besondere Genauigkeit hinsichtlich der Positionierung kann sich dadurch ergeben, dass der Ort eines Toleranzfeldes oder einer jeglichen Markierung, die eine gewünschte Position eines Bondkopfelementes repräsentiert, in der Abbildung durch eine Datenverarbeitungsanlage in Abhängigkeit des Ortes des Bezugselementes oder eines Bezugspunktes, insbesondere der Spitzes des Ultraschallwerkzeuges in der Abbildung bestimmt wird.

Aufgrund interner Kriterien des Ultraschallbonders kann somit die Position der Justage-Markierung, z.B. des Toleranzfeldes computergestützt bestimmt werden, so dass es lediglich Aufgabe eines Bedieners ist, das zu positionierende Bondkopfelement mit Bezug auf die Markierung durch Bedienung entsprechender Justagemittel zu positionieren.

Um die Darstellung einer Justage-Markierung z.B. des Toleranzfeldes in Abhängigkeit des Ortes des Bezugselementes, wie beispielsweise der Spitze des Ultraschallwerkzeuges zu ermöglichen, kann es in einer Alternative vorgesehen sein, dass der Ort des Bezugselementes manuell, insbesondere durch Markierung dieses Ortes in der Abbildung bestimmt wird. Um dies vorzunehmen, kann es beispielsweise vorgesehen sein, dass ein Bediener den entsprechenden Ort eines Bezugselementes, somit einen Referenzpunkt, in der bildlichen Darstellung auf der Anzeigevorrichtung markiert, beispielsweise durch Anklicken der Spitze oder einer Kante an der Spitze des Ultraschallwerkzeuges mittels eines Mauszeigers. Ebenso kann eine Markierung durch Berührung eines Touchscreens der Anzeigevorrichtung bewirkt werden oder durch andere geeignete Maßnahmen, um der Datenverarbeitungsanlage den Ort des Bezugselementes mitzuteilen.

Durch diese Markierung kann z.B. die genaue Position der Spitze des Ultraschallwerkzeuges rechnertechnisch erfasst werden, um sodann in Abhängigkeit dieser Position die optimale Lage der Justage-Markierung, z.B. des Toleranzfeldes zu ermitteln und diese in der Abbildung auf der Anzeigevorrichtung darzustellen.

Gemäß einer weiteren Alternative kann es ebenso vorgesehen sein, dass der Ort des Bezugselementes, z.B. der Spitze des Ultraschallwerkzeuges durch eine computergestützte Bilderkennung bestimmt wird. So kann beispielsweise mit Hilfe eines Computerprogramms eine Mustererkennung durchgeführt werden, um das Bezugselement, wie die Spitze des Ultraschallwerkzeuges in der aufgenommenen Abbildung zu erkennen und die Lage zu bestimmen. Anhand dieser automatisch computergestützten Lageerkennung kann sodann die optimale Position der Justage-Markierung, z.B. des Toleranzfeldes in der Abbildung errechnet werden, um diese dann anschließend in die Abbildung einzublenden.

Die Positionierung eines jeglichen Bondkopfelementes, wie beispielsweise einer Drahtführung oder eines Messers, muss bevorzugt in allen drei Dimensionen optimal bzw. innerhalb akzeptabler Toleranzen erfolgen. Bei der Aufnahme wenigstens der Umgebung der Spitze eines Ultraschallwerkzeuges kann jeweils immer nur eine zweidimensionale Abbildung erstellt werden, so dass in einem Justageschritt jeweils nur eine zweidimensionale optimale Positionierung der Elemente zueinander erfolgen kann.

Um eine optimale Positionierung eines Bondkopfelementes relativ zum Bezugselement, wie dem Ultraschallwerkzeug zumindest zunächst in zwei Dimensionen zu ermöglichen, kann es gemäß der Erfindung vorgesehen sein, dass von der Kamera wenigstens eine seitliche Aufsicht auf das Bezugselement, somit beispielsweise zumindest auf die Spitze des Ultraschallwerkzeuges und/oder eine Aufsicht auf das Bezugselement senkrecht dazu, wie z.B. auf die Stirnfläche der Spitze des Ultraschallwerkzeuges erfasst wird. Insbesondere wenn beide Möglichkeiten ausgeschöpft werden, ergeben sich zwei unterschiedliche Ansichten aus senkrecht zueinander stehenden Richtungen, so dass letztendlich ein Bondkopfelement hinsichtlich aller drei Dimensionen optimal positioniert werden kann.

Um die Aufsicht auf das Bezugselement, z.B. auf die Spitze des Ultraschallwerkzeuges in den verschiedenen Richtungen zu ermöglichen, kann es bevorzugt vorgesehen sein, dass zum Wechsel zwischen den Aufsichten ein Spiegel in den Strahlengang zwischen der Kamera und dem Bezugselement positioniert wird. Dieser Spiegel ist bevorzugt derart eingerichtet, dass der Strahlengang zwischen Kamera und dem Bezugselement, wie der Spitze des Ultraschallwerkzeuges um 90 Grad umgelenkt wird, wenn der Spiegel verwendet wird.

Hierbei kann es für einen Wechsel von der seitlichen Ansicht des Bezugselementes, bei dem sich z.B. die Spitzes des Ultraschallwerkzeuges bevorzugt genau in Höhe der optischen Achse der Kamera befindet, zu einer Aufsicht auf das Bezugselement, z.B. auf die Stirnfläche vorgesehen sein, dass der Bondkopf und damit das Bezugselement in Z-Richtung und bevorzugt gleichzeitig parallel zur optischen Achse der Kamera relativ zu dieser verfahren wird, insbesondere dergestalt, das die Länge des Strahlenganges konstant bleibt.

Sodann kann bei einer Betrachtung der Gesamtanlage, bei der sich der Bondkopf nach diesem Verfahren oberhalb der Kamera befindet, ein Spiegel unter 45 Grad-Orientierung unter das Bezugselement, z.B. unter die Spitze des Ultraschallwerkzeuges gefahren werden, um somit den Strahlengang entsprechend umzulenken und einen ungestörten Blick beispielsweise auf die Stirnfläche und insbesondere die Rille des Ultraschallwerkzeuges zu ermöglichen.

Mit dem erfindungsgemäßen Verfahren und dem erfindungsgemäßen Ultraschallbonder ist es bevorzugt vorgesehen sowohl eine Drahtführung als auch ein Messer relativ zur Spitze eines Ultraschallwerkzeuges zu positionieren. Grundsätzlich kann jedoch jedes erdenkliche Element an einem Bondkopf relativ zu einem beliebigen Bezugselement oder einem beliebigen Referenzpunkt positioniert werden.

Da gegebenenfalls die Lichtverhältnisse in der Umgebung der zu betrachtenden Bondkopfelemente nicht ausreichend sind, kann es in einer Weiterbildung ergänzend vorgesehen sein, dass zur Erfassung der Abbildung die zu justierenden Bondkopfelemente künstlich beleuchtet werden. Insbesondere können hierfür Leuchtdioden eingesetzt werden, die bevorzugt um das Kameraobjektiv herum angeordnet sind.

Ein Ausführungsbeispiel der Erfindung ist in den nachfolgenden Abbildungen dargestellt. Es zeigen:
- Figur 1: einen Teil eines Ultraschallbonders mit einem daran vorgesehenen Bondkopf und einer Kamera zur visuellen Betrachtung der Spitze des Ultraschallwerkzeuges;
- Figur 2: die Wiedergabe einer von der Kamera erfassten seitlichen Abbildung der Spitze des Ultraschallwerkzeuges und deren Umgebung mit weiteren Bondkopfelementen
- Figur 3: eine Kameraanordnung relativ zur Spitze des Ultraschallwerkzeuges unter Einsatz eines Spiegels zur Umlenkung des Strahlenganges
- Figur 4: die durch die Kamera erfasste Abbildung der Spitze eines Ultraschallwerkzeuges und deren Umgebung in Aufsicht auf die Stirnfläche der Spitze

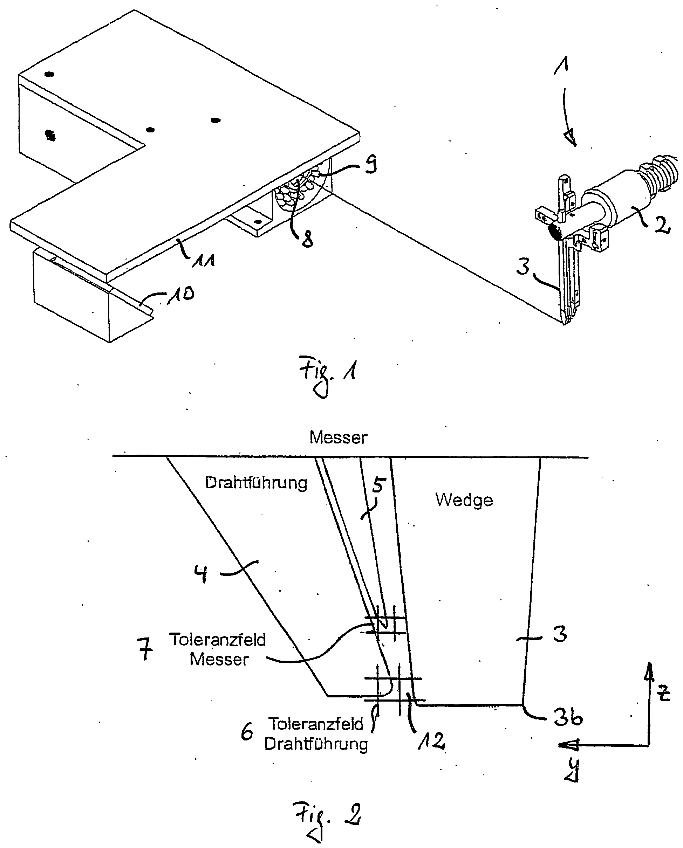

Die Figur 1 zeigt einen Teilausschnitt eines Ultraschallbonders mit einem daran angeordneten Bondkopf 1, der in üblicher Weise einen daran vorgesehenen Ultraschalltransducer 2 aufweist, an dem ein Ultraschallwerkzeug in Form eines Wedges 3 befestigt ist. Bei dem Ultraschallbonder ist weiterhin an einer entsprechenden Aufnahme eine Kamera 8 vorgesehen, die in der Darstellung gemäß Figur 1 die Spitze bzw. die Umgebung der Spitze des Ultraschallwerkzeuges 3 in seitlicher Ansicht aufnimmt.

Die Figur 2 zeigt eine entsprechende seitliche Abbildung, die auf der Anzeigevorrichtung der Kamera, beispielsweise einem Bildschirm, durch einen Benutzer zu erkennen ist. Deutlich wird die relative Anordnung der Drahtführung 4 zur Zuführung eines Drahtes 12 an die Spitze 3b des Ultraschallwerkzeuges 3 sowie des zwischen diesen Elementen angeordneten Messers 5 zum Ultraschallwerkzeug 3.

Gemäß der Erfindung kann es vorgesehen sein, dass ein Benutzer beispielsweise mit einem Mauszeiger die vordere Kante 3b der Spitze des Ultraschallwerkzeuges markiert, um einer Datenverarbeitungsanlage die Position der Spitze mitzuteilen. Gemäß einer anderen Ausführung kann es vorgesehen sein, dass die Ermittlung dieser Position durch eine Mustererkennung automatisch erfolgt.

Aufgrund der somit vorgegebenen Position der Spitze 3b des Ultraschallwerkzeuges 3 ist die Datenverarbeitungsanlage befähigt, beispielsweise durch Berücksichtigung interner Kriterien eine optimale Positionierung sowohl der Drahtführung 4 als auch in dieser Ausführung der Messerspitze 5 zu berechnen. Diese optimale Position wird im vorliegenden Fall für die Drahtführung 4 in Form eines entsprechenden Toleranzfeldes 6 innerhalb der Abbildung dargestellt. Ebenso wird die optimale Position durch ein Toleranzfeld 7 für die Positionierung der Messerspitze 5 in die Abbildung eingeblendet.

Um nun eine optimale Position dieser Elemente 4,5 zu erreichen, kann ein Benutzer z.B. durch Bedienung entsprechende Einstellmechanismen, die jeweiligen Spitzen sowohl der Drahtführung 4 als auch des Messers 5 innerhalb der dargestellten Toleranzfelder 6,7, die hier im Wesentlichen rechteckiger Ausbildung sind, anordnen.

In einer weiteren Ausführung kann es auch vorgesehen sein, dass die Datenverarbeitungsanlage eine Positionierung der Bondkopfelemente automatisch durch entsprechende Ansteuerung der Einstellmechanismen vornimmt. In einem solchen Fall kann die relative Positionierung dieser Elemente vollautomatisch vorgenommen werden.

Die Ausführung gemäß den Figuren 1 und 2 ermöglicht bei einer seitlichen Ansicht lediglich die Positionierung der Drahtführung 4 und des Messers 5 in zwei Dimensionen. Bezogen auf die Figur 2 in Y- und Z-Richtung.

Um auch eine optimale Positionierung hinsichtlich der verbleibenden Dimension in X-Richtung zu erzielen, ist es gemäß der vorliegenden Ausführung vorgesehen den Strahlengang durch einen Spiegel 10 umzulenken, was beispielsweise dadurch erfolgen kann, dass ein unter 45 Grad gekippter Spiegel 10 auf einem Haltearm 11 in den Strahlengang eingefahren wird, nachdem der Bondkopf 1 in Z-Richtung und parallel zur optischen Achse der Kamera verfahren wurde, so dass sich nunmehr durch den ungelenkten Strahlengang ein Blick der Kamera auf die Stirnfläche der Spitze des Ultraschallwerkzeuges 3 ergibt.

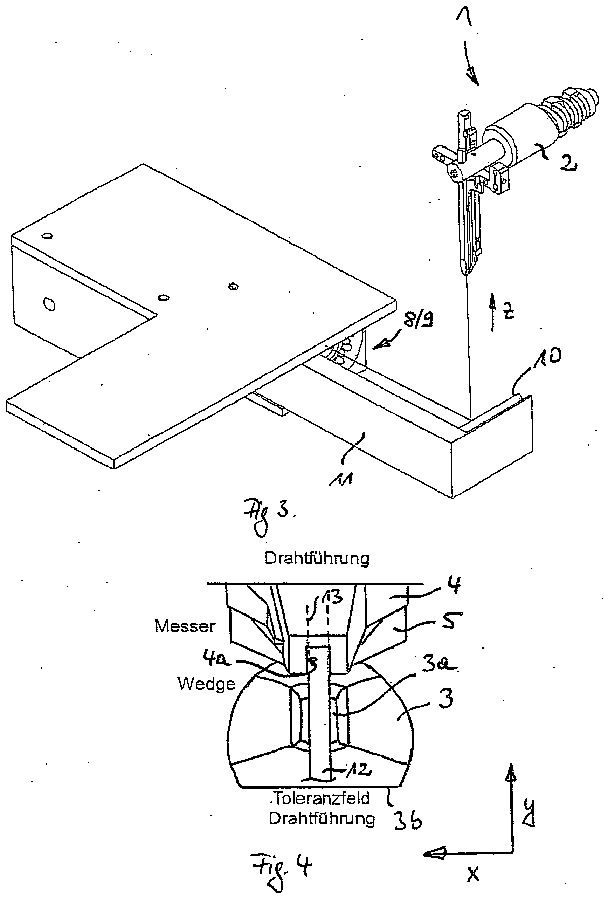

Durch eine Anordnung gemäß der Figur 3 ergibt sich somit eine Abbildung gemäß der Figur 4 in der X-Y-Ebene, bei der neben der V-förmigen Rille 3a in der Spitze des Ultraschallwerkzeuges 3 auch die jeweiligen Spitzen der Drahtführung 4 und des Messers 5 erkennbar sind. Insbesondere ist hier die Rille 4a in der Drahtführung 4 zu erkennen, die zur Zuführung eines Drahtes 12 unter die V-förmige Nut 3a des Ultraschallwerkzeuges 3 dient.

Eine optimale Positionierung ergibt sich, wenn die Rille 4a der Drahtführung 4 in ihrem Verlauf mit der V-förmigen Rille 3a des Ultraschallwerkzeuges 3 fluchtet, um den Draht 12 ungestört zuzuführen.

Um diese Positionierung aufzufinden, kann es wiederum vorgesehen sein, dass die Position anhand einer markanten Stelle an der Spitze des Ultraschallwerkzeuges, beispielsweise an der Kante 3b, durch den Benutzer manuell oder durch einen Computer durch Mustererkennung bestimmt wird. In Abhängigkeit von dieser Positionsbestimmung kann eine Markierung oder ein Toleranzfeld 13, hier beispielsweise in Form zweier paralleler Linien auf der Abbildung eingeblendet werden, um somit die optimale Positionierung der Rille 4a der Drahtführung 4 zu ermöglichen. Diese Positionierung ist erreicht, wenn die Seitenwände der Rille 4a mit den Linien des Toleranzfeldes 13 fluchten, wie es in der Abbildung 4 dargestellt ist.

Insbesondere durch die Umlenkung des Strahlenganges mittels eines Spiegels 10 kann somit eine optimale Positionierung der Bondkopfelemente, beispielsweise einer Drahtführung und eines Messers, relativ zur Spitze eines Ultraschallwerkzeuges in allen drei Dimensionen erreicht werden.

Sollten die Lichtverhältnisse nicht ausreichend sein, so kann es, wie hier dargestellt, vorgesehen sein, dass um das Kameraobjektiv Leuchtdioden 9 angeordnet sind, die für eine ausreichende Beleuchtung in der Umgebung der Spitze des Ultraschallwerkzeuges 3 sorgen.

## Patentansprüche

1. Verfahren zur Durchführung von Einstellarbeiten an einem Bondkopf (1), bei denen ein Bondkopfelement (4, 5) relativ zu einem Bezugselement, insbesondere einem Ultraschallwerkzeug (3) positioniert wird, **dadurch gekennzeichnet, dass** mittels einer Kamera (8) wenigstens eine Umgebung des Bezugselementes, insbesondere der Spitze des Ultraschallwerkzeugs (3) optisch erfasst und in einer Abbildung auf einer Anzeigevorrichtung angezeigt wird, wobei in die Anzeige eine Markierung als Hilfsmittel zur Positionierung eingeblendet wird, und wobei das Bondkopfelement (4, 5) relativ zum Bezugselement in allen drei Dimensionen positioniert wird, indem von der Kamera eine seitliche Aufsicht auf das Bezugselement und eine Aufsicht auf das Bezugselement senkrecht hierzu erfasst wird.

2. Verfahren nach Anspruch 1, **dadurch gekennzeichnet, dass** ein Bondkopfelement (4,5) derart eingestellt wird, dass es in der Abbildung in einer gewünschten, der Markierung entsprechenden Position (6,7,13) relativ zum Bezugselement (3) erscheint.

3. Verfahren nach Anspruch 2, **dadurch gekennzeichnet, dass** eine Markierung (6,7,13) in Form eines Toleranzfeldes in der Abbildung relativ zum Bezugselement (3), insbesondere relativ zur Spitze des Ultraschallwerkzeuges (3) dargestellt wird.

4. Verfahren nach einem der vorherigen Ansprüche, **dadurch gekennzeichnet, dass** der Ort eines Toleranzfeldes (6,7,13) in der Abbildung durch eine Datenverarbeitungsanlage in Abhängigkeit des Ortes des Bezugselementes, insbesondere der Spitze des Ultraschallwerkzeuges (3) in der Abbildung bestimmt wird.

5. Verfahren nach einem der vorherigen Ansprüche, **dadurch gekennzeichnet, dass** der Ort des Bezugselementes (3) manuell, insbesondere durch Markierung in der Abbildung und/oder durch computergestützte Bilderkennung bestimmt wird.

6. Verfahren nach einem der vorherigen Ansprüche, **dadurch gekennzeichnet, dass** zur Positionierung eines Bondkopfelementes (4,5) von der Kamera (8) wenigstens eine seitliche Aufsicht auf das Bezugselement, insbesondere die Spitze des Ultraschallwerkzeuges (3) und/oder eine Aufsicht auf das Bezugselement, insbesondere die Stirnfläche der Spitze des Ultraschallwerkzeuges (3) erfasst wird.

7. Verfahren nach Anspruch 5, **dadurch gekennzeichnet, dass** zum Wechsel zwischen den Aufsichten ein Spiegel (10) in den Strahlengang zwischen Kamera (8) und Bezugselement (3) positioniert wird.

8. Verfahren nach Anspruch 6, **dadurch gekennzeichnet, dass** zum Erfassen einer Aufsicht auf das Bezugselement (3) der Bondkopf (1) in Z-Richtung und parallel zur optischen Achse der Kamera (8) verfahren wird, insbesondere derart, dass der Fokusabstand konstant bleibt.

9. Verfahren nach einem der vorherigen Ansprüche, **dadurch gekennzeichnet, dass** als Bondkopfelement (4,5) eine Drahtführung (4) und/oder ein Messer (5) relativ zur Spitze eines Ultraschallwerkzeuges (3) positioniert wird.

10. Verfahren nach einem der vorherigen Ansprüche, **dadurch gekennzeichnet, dass** zur Erfassung der Abbildung die Bondkopfelemente (4,5) künstlich beleuchtet werden, insbesondere durch um ein Kameraobjektiv angeordnete Leuchtdioden (9).

11. Ultraschallbonder mit einem Bondkopf (1), der ein Ultraschallwerkzeug (3) aufweist und wenigstens ein positionierbares Bondkopfelement (4, 5), **dadurch gekennzeichnet, dass** der Ultraschallbonder zur Unterstützung der Positionierung eines Bondkopfelementes (4, 5) relativ zu einem Bezugselement eine Kamera (8) und einen Spiegel (10) aufweist, wobei mittels der Kamera (8) wenigstens eine Umgebung eines Bezugselementes, insbesondere die Spitze des Ultraschallwerkzeuges (3) optisch erfassbar ist, und wobei zur Ermöglichung der Aufsicht auf das Bezugselement in zwei verschiedenen Richtungen der Spiegel (10) derart in den Strahlengang zwischen Kamera (8) und Bezugselement positionierbar ist, dass der Strahlengang zwischen Kamera (8) und Bezugselement um 90° umgelenkt wird.

## Claims

1. Method for carrying out adjustment operations on a bond head (1), in which operations a bond head element (4, 5) is positioned relative to a reference element, in particular an ultrasonic tool (3), **characterised in that** by means of a camera (8) at least one environment of the reference element, in particular the tip of the ultrasonic tool (3), is optically detected and displayed in an image on a display device, a marking being overlaid on the display as a positioning aid, and the bond head element (4, 5) being positioned relative to the reference element in all three dimensions **in that** a side view of the reference element and a view of the reference element perpendicular thereto are detected by the camera.

2. Method according to claim 1, **characterised in that** a bond head element (4, 5) is adjusted in such a way that it appears in the image in a desired position (6, 7, 13), corresponding to the marking, relative to the reference element (3).

3. Method according to claim 2, **characterised in that** a marking (6, 7, 13) is displayed in the form of a tolerance field in the image relative to the reference element (3), in particular relative to the tip of the ultrasonic tool (3).

4. Method according to any of the preceding claims, **characterised in that** the location of the tolerance field (6, 7, 13) in the image is determined by a data processing system as a function of the location of the reference element, in particular the tip of the ultrasonic tool (3).

5. Method according to any of the preceding claims, **characterised in that** the location of the reference element (3) is determined manually, in particular by way of a marking in the image and/or by computer-assisted image detection.

6. Method according to any of the preceding claims, **characterised in that** for positioning a bond head element (4, 5) at least one side view of the reference element, in particular the tip of the ultrasonic tool (3), and/or a view of the reference element, in particular the end face of the tip of the ultrasonic tool (3), are detected by the camera (8).

7. Method according to claim 5, **characterised in that** for changing between the views a mirror (10) is positioned in the beam path between the camera (8) and the reference element (3).

8. Method according to claim 6, **characterised in that** for detecting a view of the reference element (3) the bond head (1) is displaced in the Z direction and parallel to the optical axis of the camera (8), in particular in such a way that the focal distance remains constant.

9. Method according to any of the preceding claims, **characterised in that** a wire guide (4) and/or a blade (5) are positioned relative to the tip of an ultrasonic tool (3) as a bond head element (4, 5).

10. Method according to any of the preceding claims, **characterised in that** for detecting the image the bond head elements (4, 5) are artificially illuminated, in particular by LEDs (9) arranged around a camera lens.

11. Ultrasonic bonder comprising a bond head (1) which has an ultrasonic tool (3) and at least one positionable bond head element (4, 5), **characterised in that** the ultrasonic bonder has a camera (8) and a mirror (10) for assisting in positioning a bond head element (4, 5) relative to a reference element, at least one environment of a reference element, in particular the tip of the ultrasound tool (3), being optically detectable by means of the camera (8), and the mirror (10) being positionable in the beam path between the camera (8) and the reference element in such a way that the beam path between the camera (8) and the reference element is deflected through 90°, so as to make it possible to view the reference element in two different directions.

## Revendications

1. Procédé de réalisation de travaux de réglage sur une tête de soudage (1), dans lesquels un élément de tête de sondage (4, 5) est positionné par rapport à un élément de référence, notamment un outil à ultrasons (3), **caractérisé en ce qu'**au moins un environnement de l'élément de référence, notamment de la pointe de l'outil à ultrasons (3), est saisi optiquement au moyen d'une caméra (8) et est affiché dans une image sur un dispositif d'affichage, dans lequel un marquage est affiché dans l'affichage en tant qu'aide pour le positionnement, et dans lequel l'élément de tête de soudage (4, 5) est positionné dans toutes les trois dimensions par rapport à l'élément de référence du fait que la caméra détecte une vue de dessus latérale de l'élément de référence et une vue de dessus de l'élément de référence perpendiculairement à celle-ci.

2. Procédé selon la revendication 1, **caractérisé en ce qu'**un élément de tête de soudage (4,5) est réglé de manière à ce qu'il apparaisse dans l'image dans une position (6, 7, 13) souhaitée, correspondant au marquage, par rapport à l'élément de référence (3).

3. Procédé selon la revendication 2, **caractérisé en ce qu'**un marquage (6, 7, 13) sous forme d'un champ de tolérance est représenté dans l'image par rapport à l'élément de référence (3), notamment par rapport à la pointe de l'outil à ultrasons (3).

4. Procédé selon l'une quelconque des revendications précédentes, **caractérisé en ce que** l'endroit d'un champ de tolérance (6, 7, 13) dans l'image est déterminé dans l'image par un ordinateur en fonction de l'endroit de l'élément de référence, notamment de la pointe de l'outil à ultrasons (3).

5. Procédé selon l'une quelconque des revendications précédentes, **caractérisé en ce que** l'endroit de l'élément de référence (3) est déterminé manuellement, notamment par marquage dans l'image et/ou par reconnaissance d'image assistée par ordinateur.

6. Procédé selon l'une quelconque des revendications précédentes, **caractérisé en ce que** pour le positionnement d'un élément de tête de soudage (4, 5), la caméra détecte au moins une vue de dessus latérale de l'élément de référence, notamment la pointe de l'outil à ultrasons (3) et/ou une vue de dessus de l'élément de référence, notamment la face frontale de la pointe de l'outil à ultrasons (3).

7. Procédé selon la revendication 5, **caractérisé en ce que** pour le changement entre les vues de dessus, un miroir (10) est positionné dans la trajectoire de faisceau entre la caméra (8) et l'élément de référence (3).

8. Procédé selon la revendication 6, **caractérisé en ce que** pour détecter une vue de dessus de l'élément de référence (3), la tête de soudage (1) est déplacée en direction Z et parallèlement à l'axe optique de la caméra (8), notamment de façon à ce que la distance focale reste constante.

9. Procédé selon l'une quelconque des revendications précédentes, **caractérisé en ce qu'**un guidage de fil (4) et/ou une lame (5) sont positionnés par rapport à la pointe de l'outil à ultrasons (3) en tant qu'élément de tête de soudage (4,5).

10. Procédé selon l'une quelconque des revendications précédentes, **caractérisé en ce que** pour détecter l'image, les éléments de tête de soudage (4,5) sont éclairés de manière artificielle, notamment par des diodes électroluminescentes (9) disposées autour d'un objectif de caméra.

11. Dispositif de soudage par ultrasons comprenant une tête de soudage (1) qui présente un outil à ultrasons (3) et au moins un élément de tête de soudage (4, 5) pouvant être positionné, **caractérisé en ce que** le dispositif de soudage par ultrasons présente une caméra (8) et un miroir (10) destinés à assister le positionnement d'un élément de tête de soudage (4, 5) par rapport à un élément de référence, dans lequel au moins un environnement d'un élément de référence, notamment la pointe de l'outil à ultrasons (3), peut être détecté optiquement, et dans lequel, pour permettre la vue de dessus de l'élément de référence dans deux directions différentes, le miroir (10) peut être positionné dans la trajectoire du faisceau entre la caméra (8) et l'élément de référence de manière à ce que la trajectoire de faisceau soit déviée de 90° entre la caméra (8) et l'élément de référence.
